# EUROPÄISCHE PATENTANMELDUNG

(11) **EP 2 472 275 A2**
(43) Veröffentlichungstag der Anmeldung: **04.07.2012**
(21) Anmeldenummer: 11192367.8
(22) Anmeldetag: 07.12.2011
(51) Int. Cl.: G01R 31/12, G01M 7/02

(54) **Faseroptischer Sensor sowie Messeinrichtung mit einem faseroptischen Sensor**

(30) Priorität: 28.12.2010 DE 102010061605
(71) Anmelder: BAM Bundesanstalt für Materialforschung und -prüfung, 12205 Berlin (DE)
(72) Erfinder: Jahnz, Gesine, 10997 Berlin (DE); Buchholz, Uwe, 10825 Berlin (DE)
(74) Vertreter: Zimmermann & Partner

(57) **Zusammenfassung**

Es wird ein faseroptischer Sensor (20, 30) zur Erfassung einer mechanischen Größe angegeben. Der Sensor umfasst einen Körper (201) mit einem Hohlraum (202) in den ein erster Lichtleiter (21) und ein zweiter Lichtleiter (22) mit ihren jeweiligen Endstücken (211, 221) angeordnet sind. Die Endstücke (211, 221) sind haben eine zur jeweiligen Faserachse (215, 225) nicht senkrecht verlaufende Stirnfläche (213, 223). Das Endstück (221) des zweiten Lichtleiters (22) ist biegeschwingungsfähig in dem Hohlraum (202) angeordnet. In einer Ruhelage sind die zu Endstück (211, 221) koaxial und die Stirnflächen (213, 223) im Wesentlichen parallel zueinander. Außerdem werden eine zugehörige Messeinrichtung (60), ein zugehöriges Verfahren und eine zugehörige Hochspannungsanlage (100, 200) angegeben.

## Beschreibung

Die vorliegende Erfindung betrifft einen faseroptischen Sensor, insbesondere einen faseroptischen Sensor zur Detektion von Teilentladungen (TE) in einer Isolierung in Hochspannungsanlagen sowie eine zugehörige Messeinrichtung, ein zugehöriges Verfahren und eine zugehörige Hochspannungsanlage, insbesondere eine zugehörige Hochspannungsgarnitur.

In elektrischen Anlagen zur Energieversorgung kommt es auf Grund von schädigenden Einflüssen auf die Hochspannungsgarnitur und Alterungserscheinungen der Isolierungen immer wieder zu Ausfällen. Hauptsächlich werden diese Ausfälle durch Teilentladungen verursacht. Während der Teilentladungen entstehen sogenannte Teilentladungsbäumchen, die im Laufe der Zeit wachsen und schließlich zu einem elektrischen Durchschlag führen, falls die betroffenen Anlagen nicht rechtzeitig abgeschaltet werden. Teilentladungen in Isolierungen von Kabelgarnituren, wie Endverschlüsse und Kabelmuffen für Starkstromkabel bzw. Hochspannungskabel, können in fortgeschrittenem Stadium daher zur Totalzerstörung der Kabelgarnituren führen. Auf Grund der mit dem Durchschlag verbundenen hohen Energiefreisetzung können dabei weitere Teile der Anlagen beschädigt werden. Die Schäden dieser zwar eher seltenen Ereignisse können daher beträchtlich sein. Daher besteht ein Bedarf, Alterungserscheinungen bzw. Teilentladungen in Isolierungen von Hochspannungsgarnituren möglichst im laufenden Betrieb zuverlässig zu detektieren und zu bewerten.

Eine bisher etablierte Methode besteht in der Messung elektrischer Stromimpulse und/oder elektromagnetischer Signale, die mit dem Auftreten von Teilentladungen verbunden sind. Die Interpretation dieser Messergebnisse ist unter Praxisbedingungen wegen elektromagnetischer Störungen jedoch häufig schwierig. Außerdem sind diese Messungen sehr aufwendig und erfordern typischerweise den Aufbau geeigneter Mess- und Prüfanlagen vor Ort. Daher erfolgt die Überwachung typischerweise nur in größeren Zeitabständen oder bei Vermutung entstehender Schädigungen. Elektromagnetische Messungen werden typischerweise nur in sicheren Zugangsbereichen, d.h. außerhalb des Hochspannungsbereichs, durchgeführt. Auf Grund der relativ hohen Störanfälligkeit dieser Messungen gegenüber elektromagnetischen Umweltstörungen können Teilentladungen aber oft den untersuchten Bauteil nicht eindeutig zugeordnet werden.

Im Hinblick auf das oben Gesagte, schlägt die vorliegende Erfindung einen faseroptischen Sensor zur Detektion einer eine Schwingung charakterisierende Größe gemäß Anspruch 1, eine Messeinrichtung gemäß Anspruch 9, eine Hochspannungseinrichtung gemäß Anspruch 12 und ein Verfahren gemäß Anspruch 14 vor.

Gemäß einem Ausführungsbeispiel umfasst der faseroptische Sensor einen Körper mit einem Hohlraum, einen ersten Lichtleiter und einen zweiten Lichtleiter. Die Begriffe "Lichtleiter" und "Lichtfaser" werden im Folgenden synonym verwendet. Ein Endstück des ersten Lichtleiters ist zumindest teilweise in dem Hohlraum angeordnet und weist eine zu seiner Faserachse nicht senkrecht verlaufende Stirnfläche auf. Der Hohlraum kann in einer Ebene senkrecht zur Faserachse des ersten Lichtleiters beispielsweise einen kreisförmigen oder einen rechteckigen Querschnitt aufweisen. Die Begriffe "Stirnfläche" und "Faserendfläche" werden im Folgenden synonym verwendet. Ein Endstück des zweiten Lichtleiters ist biegeschwingungsfähig im Hohlraum angeordnet. In einer Ruhelage ist das Endstück des zweiten Lichtleiters koaxial zu dem Endstück des ersten Lichtleiters angeordnet. Außerdem weist das Endstück des zweiten Lichtleiters eine zu seiner Faserachse nicht senkrecht verlaufende Stirnfläche auf, die in der Ruhelage im Wesentlichen parallel zur Stirnfläche des ersten Lichtleiters ist. Die Stirnflächen der beiden Lichtleiter können beispielsweise durch einen zur jeweiligen Faserachse entsprechend gewinkelt verlaufenden Anschliff gebildet sein. Bei dem ersten Lichtleiter und dem zweiten Lichtleiter handelt es sich typischerweise um Glas- oder Kunststofflichtleiter mit einem inneren Faserkern und einem den Faserkern umgebenden Mantel mit einer höheren Brechzahl als der Faserkern. Der Hohlraum ist typischerweise gasgefüllt, z.B. luftgefüllt. Wenn das Endstück des zweiten Lichtleiters durch ein äußeres Ereignis, typischerweise durch ein Schallereignis, zu Biegeschwingungen angeregt wird, verändern sich die Abstände der beiden Stirnflächen und damit die Lichtübertragungseigenschaften zwischen dem ersten Lichtleiter und dem zweiten Lichtleiter. Dies ermöglicht eine einfache optische Messung von Schallereignissen. Falls es sich bei dem Körper 201 um einen deformierbaren Körper handelt, so kann der faseroptische Sensor auch als Deformationssensor eingesetzt werden.

Die Formulierung "eines biegeschwingungsfähig im Hohlraum angeordneten Endstücks", wie sie vorliegend verwendet wird, soll insbesondere Anordnungen des Endstücks im Hohlraum umfassen, die resonant anregbare Biegeschwingungen des Endstücks mit maximalen Amplituden bis etwa 5 µm ermöglichen. Typischerweise ist das Endstück des zweiten Lichtleiters durch Schallwellen anregbar, Biegeschwingungen bei mindestens einer Frequenz aus einem Bereich von etwa 5 kHz bis etwa 500 kHz auszuführen. Dazu kann bei gegebenen Materialeigenschaften eine Länge des Endstücks des zweiten Lichtleiters entsprechend dimensioniert werden. Beispielsweise kann das Endstück des zweiten Lichtleiters so ausgeführt sein, dass es eine Resonanzfrequenz im Bereich von etwa 10 kHz bis etwa 100 kHz aufweist, der typisch für Schallereignisse auf Grund von Teilentladungen in Isoliermaterialien ist.

Der Begriff "Teilentladung", wie er vorliegend verwendet wird, soll kurzzeitige, energiearme und lokal begrenzte Entladungen in der Isolierung, die nicht sofort zu einem elektrischen Durchschlag führen, aber das Material der Isolierung irreversibel schädigen, beschreiben. Der Begriff "Teilentladung" soll insbesondere den Begriff der "inneren Teilentladung", d.h. einer äußerlich nicht unbedingt sichtbaren Entladungserscheinungen in nicht gasförmigen Isoliermaterialien, insbesondere in festen Isoliermaterialien, umfassen. Ausgehend von Fehlstellen, wie Hohlräumen und Fremdeinschlüssen oder Grenzflächen zu anderen Materialien, insbesondere zu hochspannungsführenden Leitern, führen Teilentladungen zu im Laufe der Zeit wachsenden Teilentladungsbäumchen im Isoliermaterial, was schließlich zu einem Durchschlag führen kann. Teilentladungsbäumchen haben typischerweise eine Größe von mehr als etwa 1 µm (Mikrometer). Als Maß für die Stärke einer Teilentladung kann die direkt an den Prüfanschlüssen einer elektrischen Messanordnung messbare scheinbare Ladung verwendet werden. Der Begriff "Teilentladung", wie er vorliegend verwendet wird, soll insbesondere Entladungen in der Isolierung mit scheinbaren Ladungen von mehr als ca. 1 pC umfassen. Je nach Stärke sind Teilentladungen mit kurzen Schallemissionen im Bereich von etwa 10 kHz bis etwa einigen Hundert kHz verbunden. Durch elektrochemische Veränderungen (Reaktionsschwund) und/oder während der Teilentladungen können sich mechanische Spannungen entwickeln und in deren Folge Risse und Spalten im Isoliermaterial bilden.

Die Formulierung "einer zur Faserachse nicht senkrecht verlaufende Stirnfläche", wie sie vorliegend verwendet wird, soll eine Stirnfläche beschreiben, deren Tangentenwinkel zumindest im Mittel nicht senkrecht zur Faserachse des Endstücks ist. Typischerweise bilden dabei alle Tangenten an die Stirnfläche mit der Faserachse einen Winkel, der kleiner als 90° ist. Beispielweise können die beiden Stirnflächen als ebene Flächen ausgeführt sein, deren Normalenwinkel nicht parallel zur jeweiligen Faserachse sind. Typischerweise verlaufen die beiden Stirnflächen jeweils in einem Winkel von etwa 45° zur Faserachse des jeweiligen Endstücks. Zumindest eine der beiden Stirnflächen kann jedoch auch durch eine konvexe Oberfläche gebildet sein, dessen Krümmungsradius wesentlich größer, z.B. zumindest 10-mal größer, als ein Durchmesser des jeweiligen Lichtleiters bzw. Endstücks sein. In diesem Fall bildet eine mittlere Tangente der konvexen Oberfläche mit der Faserachse des jeweiligen Lichtleiters bzw. Endstücks typischerweise einen Winkel von etwa 45°.

Die Formulierung von "im Wesentlichen parallelen Stirnflächen", wie sie vorliegend verwendet wird, soll Anordnungen zweier Stirnflächen beschreiben, die im Rahmen der Justiergenauigkeit von weniger als etwa 5° oder sogar weniger als etwa 1° parallel zueinander orientiert sind und/oder parallel zueinander orientierte mittlere Tangenten aufweisen. Die Formulierung von "im Wesentlichen parallelen Stirnflächen" umfasst insbesondere ebene Stirnflächen, die im Rahmen der Justiergenauigkeit parallel zueinander angeordnet sind, aber auch Stirnflächen mit Oberflächenkrümmungen, deren Krümmungsradius wesentlich größer, z.B. 10-fach oder sogar 100-fach größer, als ein Durchmesser der jeweiligen Endstücke ist, und die so zueinander angeordnet sind, dass die Stirnflächen bei Vernachlässigung der Oberflächenkrümmung im Rahmen der Justiergenauigkeit parallel zueinander sind.

Gemäß einer Weiterbildung entspricht der Winkel zwischen der Faserachse und einer Tangente an die Stirnfläche des zweiten Lichtleiters und/oder des ersten Lichtleiters einem Totalreflektionswinkel für eine Lichtwellenlänge eines Lichtsignals, für dessen Transport der erste Lichtleiter und der zweite Lichtleiter eingerichtet sind.

Gemäß noch einer Weiterbildung ist ein minimaler Abstand der beiden Stirnflächen in der Ruhelage kleiner als die Wellenlänge des Lichtsignals für dessen Transport der erste Lichtleiter und der zweite Lichtleiter eingerichtet sind. Beispielsweise können sich die beiden Stirnflächen in der Ruhelage berühren. Dadurch können, je nach Wellenlänge, Biegeschwingungen des zweiten Endstücks mit Amplituden im nm-Bereich über eine sich ändernde evaneszente Lichtübertragung zwischen dem ersten Lichtleiter und dem zweiten Lichtleiter hochempfindlich gemessen werden. Ein derartiger faseroptischer Sensor ermöglicht daher die Detektion von sehr schwachen Schallereignissen.

Gemäß noch einer Weiterbildung wird der Körper durch eine Glaskapillare oder eine Glasküvette gebildet. Dadurch können, je nach Wellenlänge, Biegeschwingungen des zweiten Endstücks mit Amplituden im µm-Bereich über eine Messung des in die zweite Lichtleitfaser rückgekoppelten Lichts aus einem sich zwischen der inneren Wand der Glaskapillare bzw. Glasküvette und der Stirnfläche des zweiten Lichtleiters gebildeten Fabry-Perot-Resonators hochempfindlich gemessen werden. Ein derartiger faseroptischer Sensor ermöglicht somit die Detektion von mittleren und starken Schallereignissen.

Gemäß einem Ausführungsbeispiel umfasst die Messeinrichtung zur Detektion von mechanischen Schwingungen neben dem faseroptischen Sensor, einen ersten Fotodetektor, der mit dem ersten Lichtleiter oder mit dem zweiten Lichtleiter optisch gekoppelt ist, eine Lichtquelle, z.B. einen Laser, zum Aussenden eines Lichtsignals, einen dritten Lichtleiter, einen mit dem dritten Lichtleiter optisch gekoppelten zweiten Fotodetektor, und einen optischen Koppler, z.B. einen 3 dB-Koppler. Wenn der erste Fotodetektor mit dem ersten Lichtleiter optisch gekoppelt ist, so ist der optische Koppler eingerichtet, das Lichtsignal zumindest teilweise in den zweiten Lichtleiter einzuspeisen und ein durch den zweiten Lichtleiter rücklaufendes Lichtsignal zumindest teilweise in den dritten Lichtleiter einzuspeisen. Wenn der erste Fotodetektor mit dem zweiten Lichtleiter optisch gekoppelt ist, so ist der optische Koppler eingerichtet, das Lichtsignal zumindest teilweise in den ersten Lichtleiter einzuspeisen und ein durch den ersten Lichtleiter rücklaufendes Lichtsignal zumindest teilweise in den dritten Lichtleiter einzuspeisen. Diese Messeinrichtung ermöglicht eine einfache optische Messung von Schallereignissen. Der Begriff "optisch gekoppelt", wie er vorliegend verwendet wird, soll insbesondere eine direkte optische Verbindung zwischen zwei optischen Elementen und/oder Lichtfasern umfassen, so dass optische Signale zumindest in eine Richtung direkt zwischen den zwei optischen Elementen und/oder Lichtfasern ausgetauscht werden können. Typischerweise sind die zwei optischen Elemente und/oder Lichtfasern dabei auch indirektem mechanischen Kontakt.

Gemäß einer Weiterbildung ist die Messeinrichtung eingerichtet, einen Abstand und/oder eine Amplitude einer Schwingung zwischen den beiden Stirnflächen über eine Messung einer evaneszent zwischen dem zweiten Lichtleiter und dem ersten Lichtleiter übertragenen Lichtleistung und/oder Lichtmenge zu bestimmen. Damit lassen sich sehr schwache Schallereignisse zuverlässig detektieren.

Gemäß noch einer Weiterbildung ist die Messeinrichtung eingerichtet, einen Abstand und/oder eine Amplitude einer Schwingung zwischen den beiden Stirnflächen über eine Messung einer aus dem Hohlraum in den zweiten Lichtleiter rückgekoppelten Lichtleistung und/oder Lichtmenge zu bestimmen. Damit lassen sich mittlere und starke Schallereignisse zuverlässig detektieren.

Gemäß einem Ausführungsbeispiel ist die Hochspannungseinrichtung so ausgeführt, dass sie ein Hochspannungskabel mit einem zum Leiten elektrischen Stroms eingerichteten Leiter und eine den Leiter umgebenden Kabelisolierung aufnehmen kann. Die Hochspannungseinrichtung umfasst neben dem faseroptischen Sensor bzw. der den faseroptischen Sensor umfassenden Messeinrichtung eine Isolierung, mit der der Körper des faseroptischen Sensors mechanisch gekoppelt ist und die eingerichtet ist, die Kabelisolierung zumindest teilweise zu umgeben. Damit kann eine in der Isolierung der Hochspannungseinrichtung oder in der Kabelisolierung auftretende elektrische Teilentladung über eine damit verbundene Schallemission mittels des faseroptischen Sensors empfindlich nachgewiesen werden.

Der Begriff "Hochspannung", wie er vorliegend verwendet wird, soll Spannungen oberhalb von etwa 1 kV umfassen, insbesondere soll der Begriff Hochspannung die in der Energieübertragung üblichen Nennspannungsbereiche der Mittelspannung von etwa 3 kV bis etwa 50 kV, der Hochspannung von etwa 50 kV bis etwa 110 kV als auch Höchstspannungen bis derzeit etwa 500 kV umfassen. Für den Fall, dass die Kabelbetriebsspannungen weiter erhöht werden, sollen auch diese Spannungsbereiche mit umfasst werden. Dabei kann es sich sowohl um Gleichspannungen als auch um Wechselspannungen handeln. Der Begriff "Hochspannungskabel", wie er vorliegend verwendet wird, soll ein Kabel beschreiben, das dazu geeignet ist, Starkstrom, d.h. elektrischen Strom von mehr als etwa einem Ampere bei Spannungen oberhalb von etwa 1 kV, zu führen. Im Folgenden werden die Begriffe Hochspannungskabel und Starkstromkabel synonym verwendet. Dementsprechend soll der Begriff der "ochspannungsgarnitur" oder "Hochspannungskabelgarnitur" eine Vorrichtung beschreiben, die geeignet ist, Hochspannungsanlagen und/oder Hochspannungskabel miteinander zu verbinden.

Gemäß einer Weiterbildung handelt es sich bei der Hochspannungseinrichtung um eine Schaltanlage, z.B. einen Schaltschrank, oder eine Hochspannungsgarnituren, z.B. eine Kabelmuffe oder einen Kabelendverschluss, deren jeweilige Isolierung besonders hohen Feldstärken ausgesetzt und somit besonders teilentladungsgefährdet ist. Bei der Hochspannungseinrichtung kann es sich aber auch um einen Generator, einen Spannungswandler, z.B. einen Wechselrichter oder einen Transformator handeln.

Typischerweise umfasst die Isolierung einer Hochspannungsgarnitur ein Feldsteuerteil mit einem elastomerer Feldsteuerkörper, in den zur Veränderung des elektrischen Feldverlaufs in der Hochspannungsgarnitur ein Deflektor integriert ist. Das Feldsteuerteil nimmt dazu typischerweise denjenigen Raum in der Hochspannungsgarnitur ein, in dem die Feldstärke im Hochspannungsbetrieb zu groß für die übrige Isolierung ist. Das Feldsteuerteil kann insbesondere als Feldsteuerkonus mit einem integrierten leitfähigen Deflektor ausgebildet sein. Damit kann das Feldsteuerteil die Feldlinien im Hochspannungsbetrieb der Hochspannungsgarnitur so führen, dass die Feldstärke außerhalb des Feldsteuerteils hinreichend niedrig ist.

Typischerweise ist der faseroptische Sensor in direktem Kontakt mit der Isolierung, d.h. zumindest teilweise im Innern der Hochspannungseinrichtung angeordnet. Beispielsweise kann der Körper des faseroptischen Sensors zumindest teilweise in das Feldsteuerteil der Hochspannungsgarnitur eingebettet sein und sich damit während des Betriebs zumindest teilweise im elektrischen Hochspannungsfeld befinden. Dadurch können bereits relativ schwache Teilentladungen ohne aufwendige externe Messaufbauten detektiert werden. Faseroptische Sensoren können zum Einen hochempfindlich ausgeführt werden, zum Anderen können sie aus ausschließlich dielektrischen Materialien gefertigt werden, so dass sie prinzipiell im Hochspannungsfeld, d.h. nahe teilentladungsgefährdeter Gebiete oder sogar in teilentladungsgefährdeten Gebieten, eingesetzt werden können, ohne das Hochspannungsfeld signifikant zu verändern. Dies ermöglicht zudem eine einfache kontinuierliche Überwachung des Zustands der Isolierung während des Betriebs der Hochspannungsgarnitur, bspw. durch Übermittlung der Messergebnisse an eine zentrale Auswerteeinheit. So können ein drohender Durchschlag in der Hochspannungsgarnitur frühzeitig erkannt, die Anlage abgeschaltet und durch Austausch der gealterten Isolierung oder der kompletten Hochspannungsgarnitur Folgeschäden vermieden werden.

Gemäß einem Ausführungsbeispiel umfasst das Verfahren zur Detektion einer Teilentladung in einer Isolierung einer Hochspannungsanlage die Messung einer eine Schwingung charakterisierende Größe der Isolierung mittels des faseroptischen Sensors, dessen Körper mechanisch mit der Isolierung gekoppelt ist. Bei der eine Schwingung charakterisierende Größe kann es sich um ein Schwingungsamplitude, eine Schwingungsfrequenz und/oder deren zeitliche Entwicklung handeln. Dies ermöglicht eine einfache Überwachung von Teilentladungsprozessen und damit des Alterungszustands der Isolierung der Hochspannungsanlage. Typischerweise erfolgt die Messung der eine Schwingung charakterisierende Größe im stromdurchflossenen Zustand der Hochspannungsgarnitur. Damit kann die Hochspannungsgarnitur im laufenden Betrieb überwacht werden.

Gemäß einer Weiterbildung wird das Verfahren kontinuierlich und/oder ereignisgesteuert ausgeführt, wobei ein oder mehrere faseroptische Sensoren betrieben werden können. Damit soll sichergestellt werden, dass sämtliche auftretenden Teilentladungen bzw. andere schädigende Einflüsse erfasst werden. Unter dem Begriff einer "zeitlich kontinuierlichen Messung", wie er vorliegend verwendet wird, soll eine Messung verstanden werden, die auch einzelne kurze Signale im Bereich oberhalb einiger Millisekunden in einem Zeitraum von mehreren Stunden, typischerweise mehreren Tagen, oder sogar mehreren Wochen und Monaten detektieren kann. Das Verfahren kann bspw. so ausgeführt werden, dass die mit dem faseroptischen Sensor verbundenen Fotodetektoren der Messeinrichtung während eines bis über Monate andauernden Zeitraums durchgängig die vom faseroptischen Sensor gelieferten optischen Signale detektieren, die eigentliche Auswertung der Messung bzw. Bestimmung der damit korrelierten eine Schwingung charakterisierende Größe in einer Auswerteinheit jedoch nur bei einer Änderung der optischen Signale erfolgt, d.h., wenn ein durch eine elektrische Teilentladung ausgelöstes Schallereignis den Körper des faseroptischen Sensors erreicht und sich die optischen Übertragungseigenschaften des faseroptischen Sensors ändern.

Weitere vorteilhafte Ausgestaltungen, Einzelheiten, Aspekte und Merkmale der vorliegenden Erfindung ergeben sich aus den Unteransprüchen, der Beschreibung sowie den beigefügten Zeichnungen. Darin zeigt:
Fig. 1 einen schematischen Querschnitt eines faseroptischen Sensors gemäß einem Ausführungsbeispiel;
Fig. 2 einen schematischen Querschnitt eines faseroptischen Sensors gemäß einem weiteren Ausführungsbeispiel;
Fig.3 eine schematische Darstellung einer Messeinrichtung gemäß einem Ausführungsbeispiel;
Fig. 4 eine schematische Darstellung der Messeinrichtung aus Fig. 3 während einer Messung gemäß einem Ausführungsbeispiel;
Fig. 5 eine schematische Darstellung der Messeinrichtung aus Fig. 3 während einer Messung gemäß einem weiteren Ausführungsbeispiel;
Fig. 6 eine beispielhafte Messkurve, wie sie während einer Messung gemäß Fig. 5 gewonnen werden kann.
Fig. 7 eine schematische Darstellung der Messeinrichtung aus Fig. 3 während einer Messung gemäß noch einem weiteren Ausführungsbeispiel;
Fig. 8 eine beispielhafte Messkurve, wie sie während einer Messung gemäß Fig. 7 gewonnen werden kann.
Fig.9 einen schematischen Querschnitt einer Hochspannungsgarnitur gemäß einem Ausführungsbeispiel; und
Fig. 10 einen schematischen Querschnitt einer Hochspannungsgarnitur gemäß einem weiteren Ausführungsbeispiel.

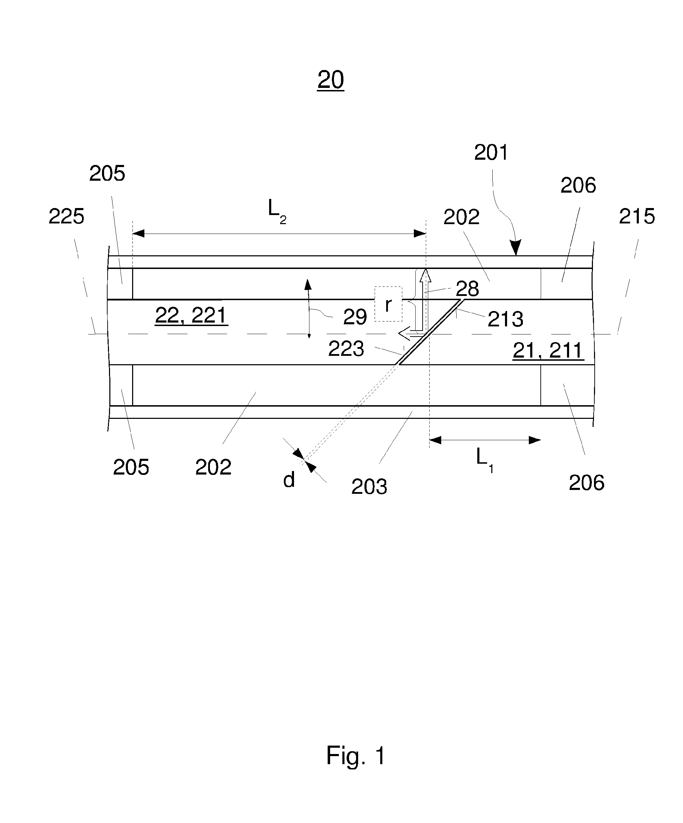

Fig. 1 zeigt einen faseroptischen Sensor 20 mit einem ersten Lichtleiter 21 und einem zweiten Lichtleiter 22 gemäß einem Ausführungsbeispiel. Die beiden Lichtleiter 21, 22 sind typischerweise zylindersymmetrisch und haben typischerweise einen Faserkern und einen den Faserkern umgebenden Mantel. Aus Gründen der Übersichtlichkeit ist der Übergang vom Faserkern zum Mantel jedoch nicht dargestellt. Der faseroptische Sensor 20 umfasst einem Körper 201 mit einem Hohlraum 202. Ein Endstück 211 des ersten Lichtleiters 21 ist zumindest mit der zur Faserachse 215 im Winkel von etwa 45° verlaufenden Stirnfläche 213 in dem Hohlraum 202 angeordnet, wie in der schematischen zentralen Querschnittsansicht entlang der Faserachse 215 in Fig. 1 gezeigt wird. Außerdem ist ein zweiter Lichtleiter 22 mit seinem Endstück 221 biegeschwingungsfähig in dem Hohlraum 202 angeordnet. Auch das Endstück 221 hat eine zu seiner Faserachse 225 im Winkel von etwa 45° verlaufende Stirnfläche 213. In der in Fig. 1 illustrierten Ruhelage des faseroptischen Sensors 20 sind die beiden Endstücke 211 und 221 koaxial zueinander und die beiden Stirnflächen 213 und 223 im Wesentlichen parallel zueinander angeordnet. Wie durch den Pfeil 29 angezeigt wird, ist das Endstück 221 so mit dem Körper 201 verbunden, dass es in der gezeigten Ebene Biegeschwingungen ausführen kann. Wenn auf den Körper 201 des faseroptischen Sensors 20 eine Schallwelle einer geeigneten Frequenz trifft, so kann das zweite Endstück 221 in Biegeschwingungen versetzt werden. Entsprechend der Biegeschwingungen wird ein minimaler Abstand d zwischen den beiden Stirnflächen 213, 223 moduliert. Dementsprechend werden die Lichtübertragungseigenschaften zwischen dem ersten Lichtleiter 21 und dem zweiten Lichtleiter 22 moduliert, so dass durch Messung der Lichtübertragungseigenschaften, z.B. der durch den faseroptischen Sensor 20 transportierten Lichtleistung oder Lichtmenge in einem gegebenen Zeitintervall, eine Amplitude und/oder eine Frequenz der Biegeschwingung bestimmt werden kann. Damit lassen sich Schallereignisse empfindlich detektieren und/oder sogar quantifizieren. Zur Quantifizierung von Schallereignissen werden typischerweise entsprechende Kalibiermessungen herangezogen.

Bei gegebenen Materialeigenschaften kann über die effektive Länge L₂ des Endstücks 221 zudem die Grundfrequenz oder Eigenfrequenz der Biegeschwingungen des Endstücks 221 eingestellt werden, wobei die Eigenfrequenz umgekehrt proportional zum Quadrat der effektive Länge L₂ ist. So liegt die Eigenfrequenz der Biegeschwingungen für eine Standardfaser mit einem Gesamtdurchmesser von 125 µm und einem 9 µm dicken Faserkern als Lichtleiter 21 bei einer effektiven Länge L₂ des Endstücks 221 von 2 mm bei etwa 24 kHz. Wenn der Sensorkörper 201 einem Schallsignal ausgesetzt ist, das die Eigenfrequenz der Biegeschwingungen des Endstücks 221 enthält, so kann das Endstück 221 zu resonanten Schwingungen angeregt werden. Ein derartiges Schallsignal kann daher besonders empfindlich detektiert werden. Typischerweise kann das Endstück 221 auch zu Oberschwingungen angeregt werden, falls das Schallsignal eine entsprechende Frequenzkomponente enthält. Da die Oberschwingungen typischerweise nichtharmonisch sind, kann ggf. aus der Frequenz der Biegeschwingung auch auf eine Schallfrequenz im Schallsignal zurückgeschlossen werden. Dazu können entsprechende Kalibiermessungen herangezogen werden, die typischerweise zudem berücksichtigen, dass die Biegeschwingung des Endstücks 221 durch das Endstück 211 in einer Richtung eingeschränkt sein kann.

Die Länge L₁ des Endstück 211 des ersten Lichtleiters 21 ist typischerweise wesentlich kleiner als die Länge L₂ des Endstück 221 des zweiten Lichtleiters 22, so dass das Endstück 211 eine wesentlich höhere Eigenfrequenz besitzt. Beispielsweise kann die Länge L₁ des Endstück 211 nur 1/10 oder weniger der Länge L₂ betragen. Entsprechend wird die Eigenfrequenz des Endstücks 211 mindestens das 100-fache der Eigenfrequenz des Endstücks 221 betragen und damit bspw. außerhalb einer erwarteten Schallfrequenz liegen. Dies vereinfacht die Signalauswertung.

Es kann aber auch vorgesehen sein, dass auch das Endstück 221 so dimensioniert ist, dass es ebenfalls zu resonanten Biegeschwingungen in einem erwarteten Frequenzbereich eines Schallereignisses fähig ist. Damit können zwei Schallfrequenzen parallel mit einem faseroptischen Sensor 20 detektiert werden.

Typischerweise sind die beiden Endstücke 211, 221 über entsprechende ringförmige Verbindungselemente 205, 206 fest mit Körper 201 verbunden, z.B. mit einem Epoxydharz eingeklebt. Die Verbindungselemente 205, 206 können auch durch einen entsprechenden Epoxydharzkörper gebildet sein.

Gemäß einem Ausführungsbeispiel haben die beiden Endstücke 211, 221 in der Ruhelage einen minimalen Abstand d, der kleiner als eine Wellenlänge ist, die für Messungen der Lichtübertragungseigenschaften zwischen dem ersten Lichtleiter 21 und dem zweiten Lichtleiter 22 verwendet werden kann. Dadurch wird ein evaneszentes Übertragen eines Lichtsignals dieser Wellenlänge zwischen den Lichtleitern 21 und 22 in der Ruhelage ermöglicht. Da die evaneszente Übertragung sehr stark vom minimalen Abstand d abhängt, können Biegeschwingungen kleiner Amplituden, typischerweise im nm-Bereich, extrem empfindlich detektiert werden.

Gemäß einem Ausführungsbeispiel sind die beiden Endstücke 211, 221 im Hohlraum einer Glaskapillare 203, z.B. einer Glaskapillare mit kreisförmigem Querschnitt, oder einer Glasküvette 203 des Körpers 201 angeordnet. Wird während einer Biegeschwingung des Endstücks 221 der minimale Abstand d größer als die Wellenlänge, so wird ein in den ersten Lichtleiter 21 von links einlaufendes Lichtsignal an der Stirnfläche 223 total reflektiert, von der inneren Oberfläche der Glaskapillare 203 oder der Glasküvette 203 wieder reflektiert und geht von dort zurück den ersten Lichtleiter 21. Dies wird in Fig. 1 durch den Pfeil 28 dargestellt. Dazu ist entspricht der Winkel zwischen der Faserachse 225 und der Stirnfläche zumindest im Gebiet des Faserkerns typischerweise einem Totalreflektionswinkel für Licht, das entlang der Faserachse 225 transportiert werden kann. Das Gebiet zwischen der Stirnfläche 223 und der inneren Oberfläche fungiert als sogenannte Kavität, deren Spiegel bei Verwendung von Glasfasern als Lichtleiter 21, 22 als 4 % reflektierende Spiegel aufgefasst werden können. Wie bei einem Fabry-Perot-Interferometer wird das in dem zweiten Lichtleiter 22 rücklaufende Lichtsignal als Funktion des Abstandes r zwischen der Stirnfläche 223 und der inneren Oberfläche moduliert. Über eine Messung des im zweiten Lichtleiter 22 rücklaufenden Lichtsignals können somit auch Biegeschwingungen mit Amplituden oberhalb der Lichtwellenlänge, typischerweise im µm-Bereich, extrem empfindlich detektiert werden.

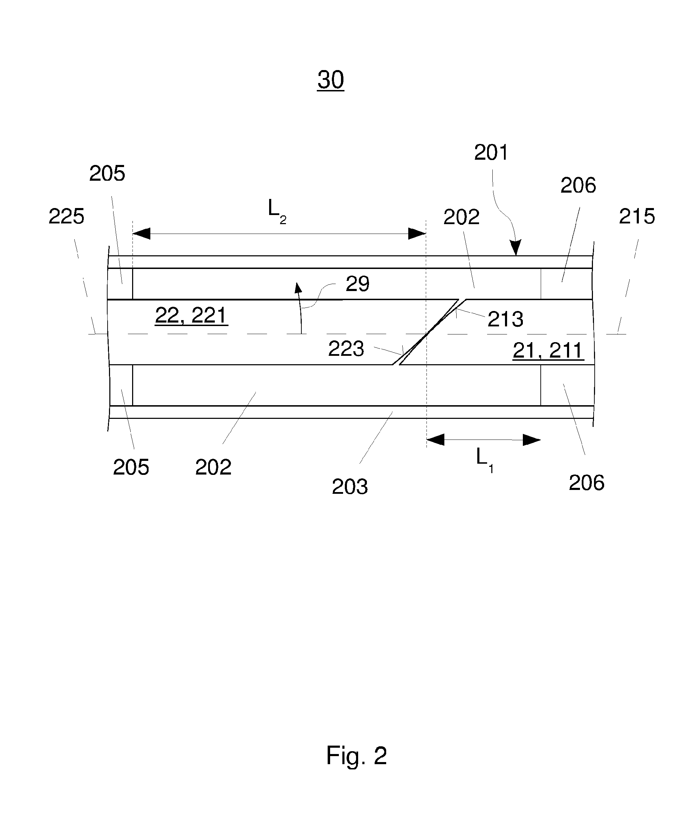

Fig. 2 zeigt einen faseroptischen Sensors 30 in einem schematischen Querschnitt entlang der Faserachsen 215, 225 der Lichtleiter 21, 22 in der Ruheposition gemäß einem weiteren Ausführungsbeispiel. Der faseroptische Sensor 30 ist ähnlich wie der faseroptische Sensor 20 aufgebaut. Beim faseroptische Sensor 30 ist jedoch die Stirnflächen 213, 223 der beiden Lichtleiter 21, 22 nicht ganz plan. Vielmehr weisen die Stirnflächen 213, 223 eine konvexe Oberfläche auf, deren Krümmungsradius jedoch groß gegenüber dem Durchmesser der Lichtleiter 21, 22 ist. Eine derartige Oberflächenkrümmung kann z.B. durch einen Poliervorgang der Stirnflächen 213, 223 erzeugt werden. Auf Grund des relativ großen Krümmungsradius ist der maximale Abstand der Stirnflächen 213, 223 in der Ruhelage ebenfalls relativ klein im Vergleich zu dem Durchmesser der Lichtleiter 21, 22, z.B. 10- mal kleiner, so dass auch die Stirnflächen 213, 223 des faseroptischen Sensors 30 in der Ruhelage als im Wesentlichen parallel zueinander angeordnet betrachtet werden können.

Im exemplarischen Ausführungsbeispiel von Fig. 2 bilden die mittleren Tangenten an die Stirnflächen 213, 223 und die jeweilige Faserachse 215, 225 jeweils einen Winkel von etwa 45°. Typischerweise bilden die Faserachse 225 und die Tangenten and die Stirnfläche 223 zumindest im Gebiet des Faserkerns des Lichtleiters 22 typischerweise einem Totalreflektionswinkel für Licht, das entlang der Faserachse 225 transportiert werden kann. Gemäß einem Ausführungsbeispiel berühren sich die Stirnflächen 213, 223 der beiden Lichtleiter 21, 22 in der Ruhelage mit ihren jeweiligen Faserkernen. Auf Grund der gekrümmten Oberflächen der Stirnflächen 213, 223 ist die Kontaktfläche sehr gering. Damit sind die Kohäsionskräfte zwischen den Endstücken 211, 221 gegenüber Ausführungsformen mit sich in der Ruhelage berührenden ebenen Stirnflächen 213, 223 verringert. Dadurch kann das Endstück 221 des zweiten Lichtleiters 22 leichter in resonante Schwingungen versetzt werden, was eine sehr empfindliche Schalldetektion ermöglicht.

Die Faserkerne der beiden Lichtleiter 21, 22 des faseroptischen Sensors 30 können in der Ruhelage aber auch einem Abstand zueinander aufweisen, der kleiner als eine Wellenlänge ist, die für Messungen der Lichtübertragungseigenschaften zwischen dem ersten Lichtleiter 21 und dem zweiten Lichtleiter 22 verwendet werden kann.
Gemäß noch einem Ausführungsbeispiel, ist nur eine der Stirnflächen 213, 223 als konvexe Oberfläche ausgebildet, während die andere der beiden Stirnflächen 213, 223 durch einen Ebene gebildet wird. Auch in diesem Ausführungsbeispiel können sich die beiden Stirnflächen 213, 223 in der Ruhelage mit einer sehr kleinen Kontaktfläche berühren.

Gemäß noch einem weiteren Ausführungsbeispiel ist das Endstück 221 des zweiten faseroptischen Sensors 22 derart im Körper 201, der typischerweise eine Glaskapillare mit rundem Querschnitt umfasst, gelagert, dass er Biegeschwingungen in einer Ebene ausführen kann, die im Wesentlichen senkrecht zur in Fig. 2 gezeigten Schnittebene ist. Auch in diesem Ausführungsbeispiel können sowohl Biegeschwingungen kleiner Amplituden, typischerweise im nm-Bereich, als auch Biegeschwingungen mit Amplituden oberhalb der Lichtwellenlänge, typischerweise im µm-Bereich, extrem empfindlich detektiert werden.

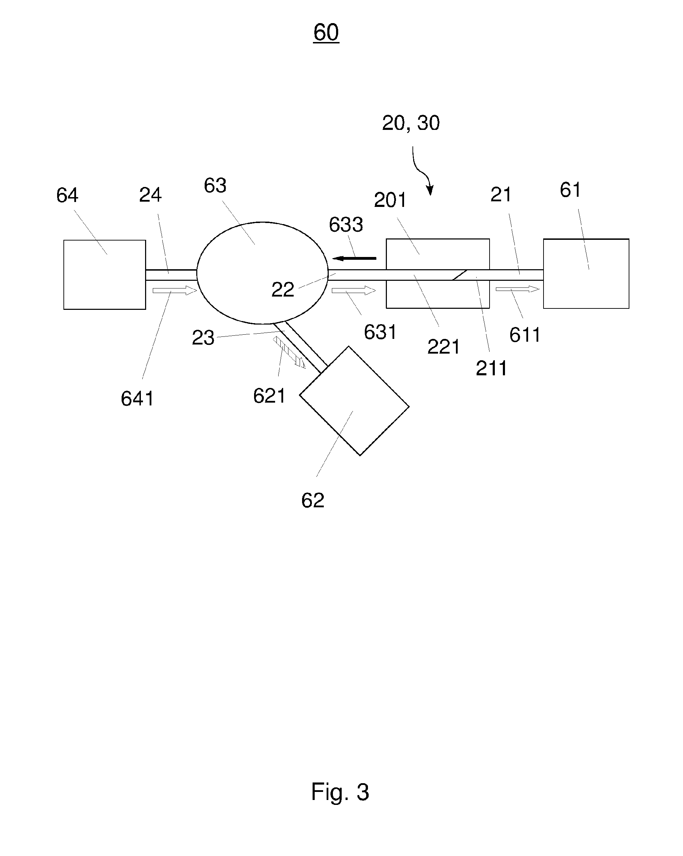

Fig.3 zeigt eine schematische Darstellung einer Messeinrichtung 60 gemäß einem Ausführungsbeispiel. Die Messeinrichtung 60 umfasst einen faseroptischen Sensor 20, 30 wie er mit Bezug zu den Figuren 1 und 2 erläutert wurde. Außerdem umfasst die Messeinrichtung 60 einen ersten Fotodetektor 61, der mit dem ersten Lichtleiter 21 des faseroptischen Sensors 20, 30 verbunden ist und eingerichtet ist, eine Messung an einem durch den ersten Lichtleiter 21 transportierten Lichtsignal 611 durchzuführen. Der zweite Lichtleiter 22 des faseroptischen Sensors 20, 30 ist optisch über einen optischen Koppler 63, z.B. einen 3-dB-Koppler, sowohl mit einer Lichtquelle 64, typischerweise einen Laser, und mit einem zweiten Fotodetektor 62 gekoppelt. Typischerweise speist die Lichtquelle 64 während der Messung ein Lichtsignal 641 über einen Lichtleiter 24 in den optischen Koppler 63, der das Lichtsignal 641 zumindest teilweise als Lichtsignal 631 in den zweiten Lichtleiter 22 einspeist. Je nach Zustand des faseroptischen Sensors 20, 30, d.h. seinen optischen Übertragungseigenschaften für das Lichtsignal 631, kann ein Teil des Lichtsignals 631 als Lichtsignal 611 in den ersten Lichtleiter 21 überkoppeln und vom angeschlossenen ersten Fotodetektor 61 gemessen werden. Ein weiterer Teil des Lichtsignals 631 kann, je nach Zustand des faseroptischen Sensors 20, 30, als Lichtsignal 622 in den zweiten Lichtleiter 22 zurückgekoppelt werden und dann über den optischen Koppler 63 und einen Lichtleiter 23 als Lichtsignal 621 einem zweiten Fotodetektor 62 zur Messung zugeführt werden. Je nach Übertragungseigenschaften des optischen Kopplers 63 kann das Lichtsignal 621 sowohl Anteile des rücklaufenden Lichtsignals 633 als auch Anteile des ursprünglichen von der Lichtquelle 64 eingespeisten Lichtsignals 641 enthalten. Bei bekannten Eigenschaften der verwendeten optischen Komponenten kann durch Messungen des zweiten Fotodetektors 62 jedoch das rücklaufende Lichtsignal 633 berechnet und damit die zustandsabhängigen optischen Übertragungseigenschaften des faseroptischen Sensors 20, 30 bestimmt werden.

Wird das Endstück 221 des faseroptischen Sensors 20, 30 z.B. durch ein Schallereignis in Schwingungen versetzt, so führt dies zu einer Modulation der optischen Übertragungseigenschaften des faseroptischen Sensors 20, 30. Über eine Vermessungen der optischen Übertragungseigenschaften des faseroptischen Sensors 20, 30 mittels des ersten Fotodetektors 61 und /oder des zweiten Fotodetektors 62 kann somit eine empfindliche Detektion und/oder Quantifizierung des Schallereignisses bereitgestellt werden.

Bei dem ersten Fotodetektor 61 und dem zweiten Fotodetektor 62 handelt es sich typischerweise um jeweils eine Fotodiode, die auf eine Wellenlängenbereich des Lichtsignals 641 der Lichtquelle 64, z.B. auf etwa 800 nm bis 1500 nm abgestimmt ist. Der erste Fotodetektor 61 und der zweite Fotodetektor 62 sind zudem typischerweise baugleich.

Es versteht sich, dass der faseroptischen Sensors 20, 30 optisch auch so mit den anderen Komponenten der Messeinrichtung 60 verbunden sein kann, dass das Lichtsignal 631 vom optischen Koppler 63 während der Messung in den ersten Lichteleiter 21 eingespeist wird, und die Messung des in den zweiten :Lichtleiter 22 übertragenen Lichtsignals 611 mittels des ersten Fotodetektors 61 erfolgt.

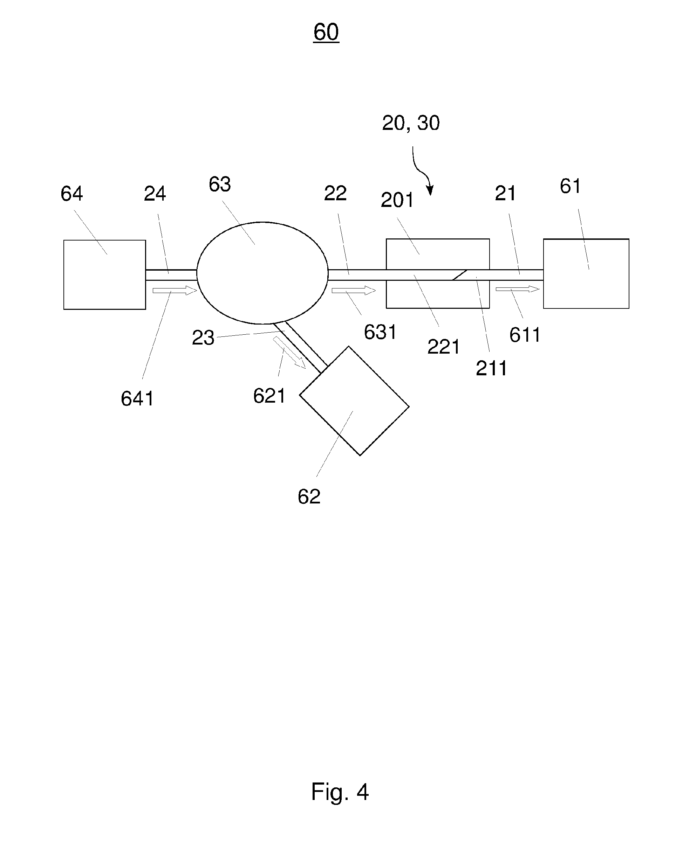

Fig. 4 illustriert in einer schematischen Darstellung eine Messung der Messeinrichtung 60 aus Fig. 3 gemäß einem Ausführungsbeispiel. Wenn sich das Endstück 221 des zweiten Lichtleiters 22 in der Ruhelage befindet, so ändern sich die optischen Übertragungseigenschaften des faseroptische Sensors 20, 30 nicht. Dementsprechend können am ersten Fotodetektor 61 und ggf. am zweiten Fotodetektor 61 bei Aussenden eines Lichtsignals 641 der Lichtquelle 64 nichtmodulierte Lichtsignale 611 bzw. 621 gemessen werden. Beispielsweise kann von der Lichtquelle 64 ein konstantes Lichtsignal 641 ausgesendet werden, was ohne externe mechanische Anregung des faseroptischen Sensors 20, 30 typischerweise zu zeitlich konstanten Lichtsignalen 611, 621 führt. Aus nichtmodulierten Lichtsignalen 611 und/oder 621 kann daher auf ein sich in seiner Ruhelage befindendes Endstück 221 des zweiten Lichtleiters 22 geschlossen werden. Dies bedeutet für eine Schallmessung, dass kein nachweisbares Schallereignis aufgetreten ist.

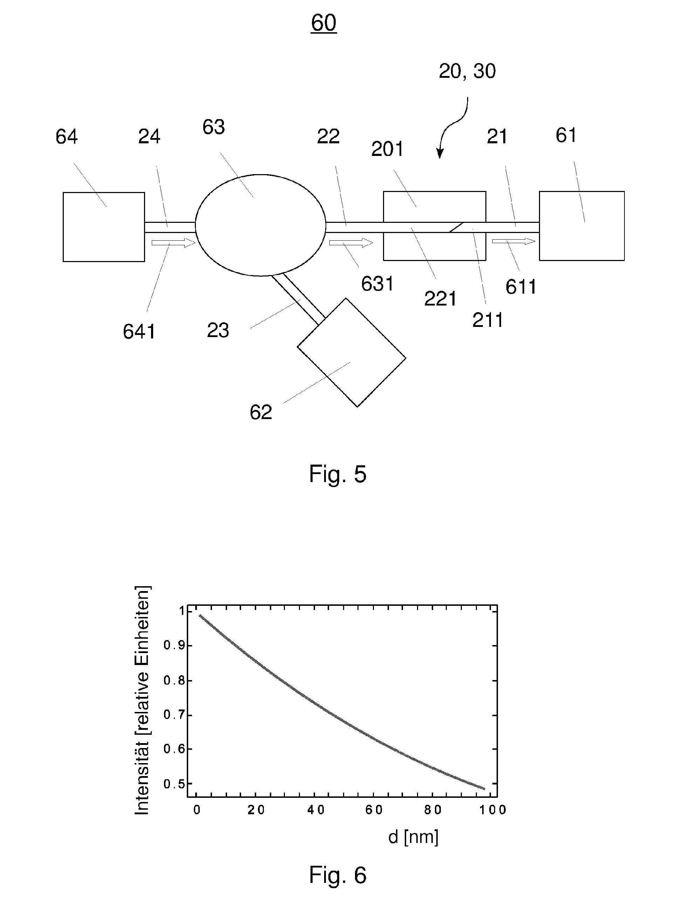

Fig. 5 illustriert in einer schematischen Darstellung eine weitere Messung der Messeinrichtung 60 aus Fig. 3 gemäß einem Ausführungsbeispiel. Wird das Endstück 221 des zweiten Lichtleiters 22 durch eine externe mechanische Anregung, z.B. durch einen auf den Körper 201 des faseroptischen Sensors 20, 30 auftreffenden Schallimpuls, in Schwingungen kleiner Amplitude versetzt, so wird das evaneszent in den ersten Lichtleiter 21 überkoppelnde Licht moduliert werden. Aus der am ersten Fotodetektor 61 gemessenen modulierten Lichtleistung und/oder Lichtmenge 611 kann die Schwingungsamplitude und/ oder Schwingungsfrequenz des Endstücks 221 bestimmt werden. Dadurch kann ein Schallereignis empfindlich detektiert und/oder quantifiziert werden. Dies wird in Fig. 6 exemplarisch verdeutlicht.

Fig. 6 zeigt eine beispielhafte Messkurve, wie sie während einer Messung gemäß Fig. 5 am ersten Fotodetektor 61 gewonnen werden kann. Die vom ersten Fotodetektor 61 während der Schwingung des Endstücks 221 messbare Intensität hängt, wie die in Fig. 6 gezeigte Kurve zeigt, vom Abstand d der beiden Endstücke 211, 221 ab, wobei in Fig. 6 die Ruhelage mit sich einander berührenden Endstücke 211, 221 einem relativem Intensitätswert 1 entspricht. Mit sich vergrößerndem Abstand d der beiden Endstücke 211, 221 nimmt die am ersten Fotodetektor 61 messbare relative Lichtintensität entsprechend ab. Falls die Messungen des Fotodetektors 61 zeitlich hochaufgelöst ausgeführt werden, z.B. mit mindestens der doppelten Messfrequenz im Verhältnis zur erwarteten Resonanzfrequenz des Endstücks 221, können sowohl die Schwingungsamplituden als auch die Schwingungsfrequenz des Endstücks 221 sowie deren zeitlicher Verlauf bestimmt. Es können aber auch integrale Messungen über eine oder mehrere Perioden der erwarteten Resonanzfrequenz des Endstücks 221 zur Detektion und zur Quantifizierung eines Schallsignals verwendet werden. Je höher die gemessene relative gemittelte relative Intensität am ersten Fotodetektor 61 ist, desto geringer ist die Schwingungsamplituden des Endstücks 221 und desto schwächer ist das am faseroptischen Sensor 20, 30 auftreffende Schallsignal.

Um die Stärke einer Schallquelle genau zu charakterisieren ist zusätzlich der Ort der Schallquelle zu bestimmen. Dies kann z.B. durch Verwendung von vier geeignet positionierten faseroptischen Sensoren 20, 30 erreicht werden. Der Ort einer Teilentladung in einer Isolierung kann über eine Messung der von der Teilentladung ausgehenden Schallereignisse mit den faseroptischen Sensoren 20, 30 typischerweise wesentlich genauer bestimmt werden als durch elektromagnetische Messungen, da die Schallgeschwindigkeit in der Isolierung um mehrere Größenordnungen geringer als die Ausbreitungsgeschwindigkeit elektromagnetischer Felder in der Isolierung ist.

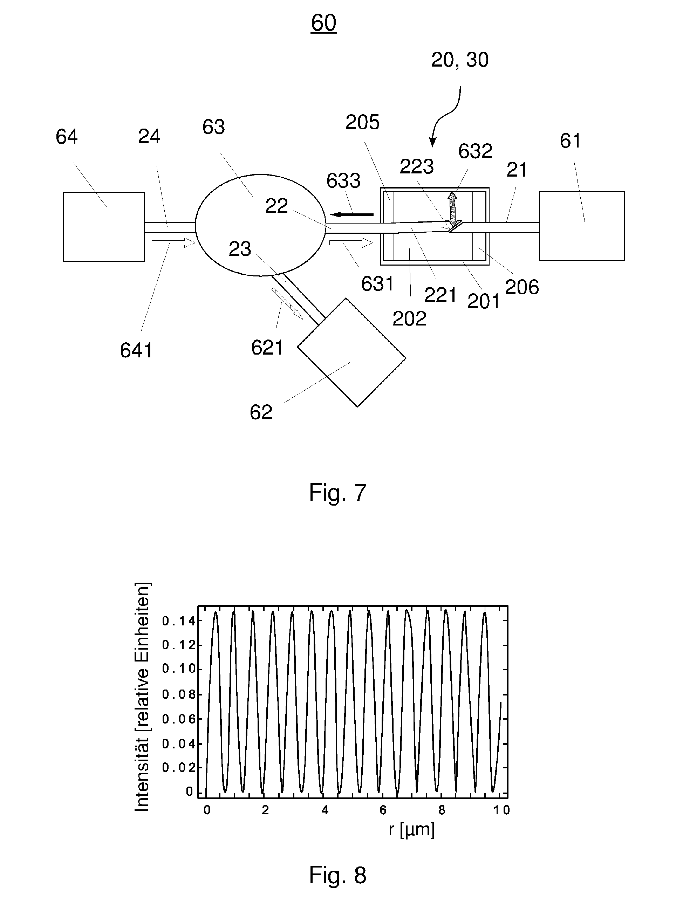

Fig.7 illustriert in einer schematischen Darstellung noch eine weitere Messung der Messeinrichtung 60 aus Fig. 3 gemäß einem Ausführungsbeispiel. Wenn der Abstand d der beiden Endstücke 211, 221 während der Schwingung des Endstücks 221 größer als die Wellenlänge des eingespeisten Lichtsignals 641 wird, so wird in dem zugehörigen Zeitintervall kein Licht mehr vom ersten Fotodetektor 61 detektiert werden können. Gleichzeitig erhöht sich typischerweise jedoch das in den zweiten Lichtleiter 22 rückreflektierte Lichtsignal 633. Über eine Messung des über den optischen Koppler 62 in die Lichtfaser 23 eingespeisten Lichtsignalanteils 621 des Lichtsignal 633 können somit auch Schwingungsamplituden von Schwingungen des Endstücks 221 bestimmt werden, die größer als die Wellenlänge des eingespeisten Lichtsignals 641 sind. Wie bereits mit Bezug zur Fig. 1 erläutert, bildet sich zwischen der Stirnfläche 223 und der inneren Oberfläche des Körpers 201 eine Fabry-Perot- Kavität 632, so dass das Lichtsignal 633 als Funktion des Abstandes r, der der Länge des die Fabry-Perot- Kavität darstellenden Pfeils 632 entspricht, zwischen der Stirnfläche 223 und der inneren Oberfläche moduliert wird. Über eine Messung des in den zweiten Lichtleiter 22 rückreflektierten Lichtsignals können somit auch Biegeschwingungen mit Amplituden oberhalb der Lichtwellenlänge, typischerweise im µm-Bereich, extrem empfindlich detektiert und/oder quantifiziert werden.

Dazu zeigt Fig. 8 eine beispielhafte Messkurve, wie sie während einer Messung gemäß Fig. 7 mittels des zweiten Fotodetektors 62 gewonnen werden kann. Die exemplarisch dargestellte relative Intensität korrespondiert zu einer halben Periode einer Schwingung mit einer Amplitude von etwa 10 µm. Entsprechend des zeitlich ansteigenden Abstandes r können mehrere Maxima und Minima der relativen Intensität am zweiten Fotodetektor 62 gemessen werden. Aus der Anzahl der gemessenen Minima und/oder Maxima der am zweiten Fotodetektor 62 gemessenen relativen Intensität bzw. aus dem kompletten Kurvenverlauf kann unmittelbar auf die Schwingungsamplitude des Endstücks 221 und damit zumindest auf die relative Stärke eines die Schwingung anregenden Schallereignisses geschlossen werden.

Die Messeinrichtung 60 kann somit über Messungen der evaneszent zwischen dem zweiten Lichtleiter 22 und dem ersten Lichtleiter 21 ausgetauschten Lichtleistung und/oder Lichtmenge schwache Schallereignisse als auch über Messungen des in den zweiten Lichtleiter 22 rückgestreuten Lichtanteils mittlere bzw. stärkere Schallereignisse detektieren und/oder quantifizieren.

Die Messeinrichtung 60 kann typischerweise aber auch über Messungen der evaneszent zwischen dem zweiten Lichtleiter 22 und dem ersten Lichtleiter 21 mittlere bzw. stärkere Schallereignisse detektieren und/oder quantifizieren, da während jeder Schwingungen des Endstücks 221 zumindest kurzzeitige evaneszente Lichtübertragungen zwischen dem zweiten Lichtleiter 22 und dem ersten Lichtleiter 21 auftreten.

Die Messeinrichtung 60 bzw. die faseroptischen Sensoren 20, 30 können zur Detektion von Schallereignissen eingesetzt werden, insbesondere zur Detektion von Schallereignissen in teilentladungsgefährdeten Isolierungen von Hochspannungseinrichtungen, was im Folgenden exemplarisch für Hochspannungsgarnituren erläutert wird.

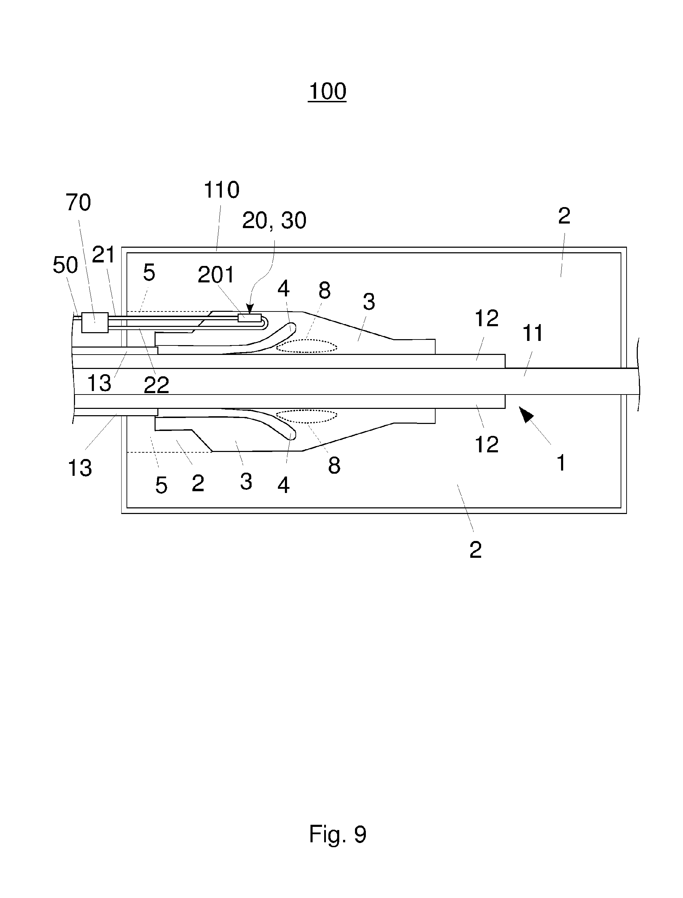

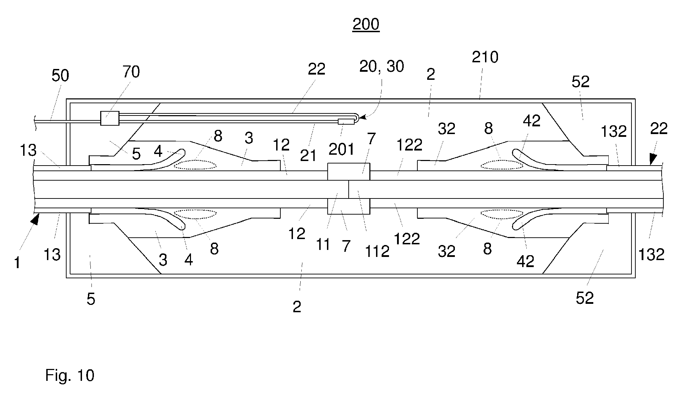

Fig. 9 zeigt eine Hochspannungsgarnitur 100 zur Aufnahme eines Hochspannungskabels 1 gemäß einem Ausführungsbeispiel in einer schematischen zentralen Querschnittsansicht entlang der Zylinderachse des Hochspannungskabels 1. Das rotationssymmetrische Hochspannungskabel 1 enthält im Innern einen Leiter 11 zum Leiten von Starkstrom, bspw. einen Aluminium- oder Kupferleiter, der von einer Kabelisolierung 12, typischerweise einer VPE-Isolierung (vernetztes Polyethylen), und einer äußeren Kabelschirmung 13, z.B. einer äußeren Leitschicht oder einem halbleitenden äußeren Kabelschirm, umgeben ist. Weiterhin kann das Hochspannungskabel 1 zusätzlich Polsterschichten und einen Kupferschirm und einen äußeren Mantel zum Schutz gegenüber Umwelteinflüssen aufweisen. Dabei kann es sich um einen Polyethylen-Mantel oder einen Mantel aus einem anderen halogenfreien Material handeln. Diese Komponenten sind in Fig. 9 und der folgenden Fig. 10 aus Gründen der Übersichtlichkeit nicht dargestellt. Außerdem kann das Hochspannungskabel 1 eine innere Leitschicht zwischen dem Leiter 11 und der VPE-Isolierung aufweisen. Diese innere Leitschicht ist ebenfalls nicht dargestellt.

Die in Fig. 9 dargestellte Hochspannungsgarnitur 100 stellt einen Kabelendverschluss 100 dar, wie er z.B. bei Freileitungen verwendet wird. Der Kabelendverschluss 100 hat ein Gehäuse 110, z.B. ein Keramikgehäuse, das die inneren Teile der Hochspannungsgarnitur 1 gegenüber der Umgebung abschließt. Im Innern des Gehäuses ist ein Isoliergebiet 2 angeordnet. Das Isoliergebiet 2 kann z.B. durch einen mit Öl oder Gas gefüllten Isolierraum gebildet werden. Das Isoliergebiet 2 bildet ein im Wesentlichen zylindersymmetrisches Gebiet.

An dem in den Kabelendverschluss eingeführten Hochspannungskabel 1 sind die äußeren Schichten (Kabelmantel, Polsterschichten und metallischer Schirm) entfernt, die typischerweise halbleitende äußere Kabelschirmung 13 bis in den Bereich des Feldsteuerteils weitergeführt und danach durch den Endverschluss hindurch bis zur Kopfarmatur nur noch die Kabelisolierung 12 mit dem Leiter 11 axial weitergeführt. Nur der Leiter 11 wird vollständig durch den Kabelendverschluss 100 geführt, um im rechten Bereich von Figur 1 nach Verlassen des Kabelendverschlusses 100 an die Freileitung angeschlossen zu werden. Im Innern des Kabelendverschlusses 100 ist der Leiter 11 nur im Bereich der entfernten Kabelisolierung vom Isoliergebiet 2 direkt umgeben. Zur Aufnahme des Hochspannungskabels 1 ist in das Isoliergebiet 2 ein rotationssymmetrisches elektrisch isolierendes Feldsteuerteil 3 eingesetzt, das denjenigen Raum innerhalb des Isoliergebietes 2 einnimmt, in dem die elektrische Feldstärke zu groß für die Isoliermaterialien im Isoliergebiet 2 wäre. Das Feldsteuerteil 3 verfügt über einen inneren Hohlzylinder, in den das Hochspannungskabel 1 eingeschoben werden kann. Beispielsweise kann das Feldsteuerteil 3 als Feldsteuerkonus ausgeführt sein. Typischerweise ist das Feldsteuerteil 3 ein elastomeres Feldsteuerteil, das aus einem Elastomerkörper besteht, z.B. aus einem Silikonelastomerkörper. Der innere Hohlzylinder ist typischerweise so dimensioniert, dass zwischen der Kabelisolierung 12 des eingeschobenen Kabels 1 und dem Feldsteuerteil 3 eine Presspassung vorliegt und das Feldsteuerteil 3 somit einen Stresskonus bildet. Das Isoliergebiet 2 und das Feldsteuerteil 3 bilden zusammen die Isolierung 2, 3 des Kabelendverschlusses 100.

Das Feldsteuerteil 3 und/oder das Hochspannungskabel 1 können zusätzlich, beispielsweise über Federn, am Gehäuse 110 oder in einem sich auf Erdpotential befindenden kabelnahen Bereich 5 des Isoliergebiets 2 fixiert werden, z.B. wenn das Isoliergebiets 2 durch einen Feststoffisolierkörper gebildet ist. Eine derartige Fixierung von Feldsteuerteil 3 und/oder Hochspannungskabel 1 wird typischerweise bei einem Aufbau des Kabelendverschlusses 100 in Komponentenbauweise verwendet. Alternativ dazu kann der Aufbau des Kabelendverschlusses 100 auch entsprechend der Wickeltechnik oder Aufschiebetechnik ausgeführt sein. Die Isolierung umfasst unabhängig von der verwendeten Bauweise ein Feldsteuerteil 3 zur Aufnahme des Kabels 1 mit teilweise entfernter Kabelisolierung 12 und zur geeigneten Führung der Feldlinien im Hochspannungsbetrieb.

Für den Abbau des elektrischen Feldes wird typischerweise ein elastomeres Feldsteuerteil 3 verwendet, in das ein geeignet geformter leitfähiger Deflektor 4 integriert ist. Der leitfähige Deflektor 4 ist in elektrischem Kontakt mit der Kabelschirmung 13. Typischerweise besteht der leitfähige Deflektor 4 ebenfalls aus einem Silikoneleastomer, der jedoch durch Dotierung über eine geeignete elektrische Leitfähigkeit verfügt. Aufgrund von Materialinhomogenitäten oder Fehlern gibt es typischerweise Bereiche erhöhter Feldstärke. Diese werden in Fig. 9 von den gestrichelt umrandeten Bereichen 8 repräsentiert. Die Wahrscheinlichkeit für das Auftreten bzw. Einsetzen von Teilentladungen ist in den Bereichen 8 mit erhöhter Feldstärke erhöht.

Gemäß einem Ausführungsbeispiel ist im Innern der Hochspannungsgarnitur 100 ein faseroptischer Sensor 20, 30 angeordnet, wie mit Bezug zu den Figuren 1 und 2 erläutert wurde. Der faseroptische Sensor 20, 30 ist mit seinem Körper 201 vollständig in das Feldsteuerteil 3 eingebettet, der die Kabelisolierung 12 des Hochspannungskabels 1 und damit dessen Leiter 11 im umgibt. Das Feldsteuerteil 3 stellt damit zumindest einen Teil einer Isolierung der Hochspannungsgarnitur 100 dar. Auf Grund der mechanischen Kopplung zwischen dem faseroptischen Sensor 20, 30 und der Isolierung, können Schallereignisse im Feldsteuerteil 3, d.h. in der Isolierung detektieren kann.

Typischerweise ist der faseroptischen Sensor 20, 30 an zumindest eine für Teilentladungen charakteristische Schallfrequenz angepasst. Beispielsweise kann das Endstück des zweiten Lichtleiters so ausgeführt sein, dass es eine Resonanzfrequenz für Biegeschwingungen im Bereich von etwas 10 kHz bis etwa 100 kHz aufweist.

Gemäß einer Weiterbildung befinden sich die andern Komponenten der mit Bezug zu den Figuren 3 bis 8 erläuterten Messeinrichtung zur Messung der Schallereignisse in einer Auswerte- und Steuereinheit 70. Um die Fotodetektoren und die ggf. vorhandene Steuer- und Auswertelektronik vor dem Hochspannungsfeld zu schützen, befindet die Auswerte- und Steuereinheit 70 typischerweise außerhalb der Hochspannungsgarnitur 100 oder im sich auf Erdpotential befindenden kabelnahen Bereich 5 des Isoliergebiets 2.

Über eine oder mehrere optische Versorgungsfasern 50 können dem passiven faseroptischen Sensor 20, 30 optische Mess- oder Prüfsignale aber auch direkt zu- und wieder abgeführt werden. Beispielsweise können die Signale der Lichtquelle über eine der optische Versorgungsfasern 50 zugeführt werden. Die Lichtquelle kann aber auch ein in die Auswerte- und Steuereinheit 70 integrierter Halbleiterlaser sein. Außerdem können die Messergebnisse der Fotodetektoren oder die Messsignale über eine oder mehrere der optischen Versorgungsfasern 50 in eine zentrale Überwachungsstelle weitergeleitet werden, so dass aufwendige Messkampagnen vor Ort entfallen können. Auf Grund der geringen Faserdämpfung sind sogar faseroptische Messungen von einer zentralen Überwachungsstelle aus über große Entfernungen möglich.

Der faseroptische Sensor 20, 30 kann sehr empfindlich mechanische Schwingungen in angrenzenden Medien und insbesondere Schallereignisse nachweisen. Außerdem ist der faseroptische Sensor 20, 30 typischerweise so ausgeführt, dass er nur aus dielektrischen Materialien besteht, z.B. aus Glas oder Polymerwerkstoff, und daher die elektrische Feldverteilung im Kabelendverschluss 100 gar nicht oder nur unwesentlich verändert. Zum anderen wird der faseroptische Sensor 20, 30 praktisch nicht durch äußere elektromagnetische Felder beeinflusst. Daher kann der faseroptische Sensor 20, 30 auch in der Nähe von Bereichen 8 mit besonders hoher Feldstärke, und daher in der Nähe von Risikobereichen, für das Detektieren von Teilentladungen positioniert werden. Damit kann eine empfindliche Überwachung von Teilentladungen während des Betriebs, d.h. unter Hochspannungsbedingungen, sichergestellt werden. Dies erhöht die Sicherheit des Betriebs von Hochspannungsanlagen.

Falls die effektive Dielektrizitätskonstante des faseroptischen Sensors 20, 30 von der Dielektrizitätskonstante des Feldsteuerteils 3 abweicht, kann es zu einer Veränderung der elektrischen Feldverteilung im Feldsteuerteil 3 kommen. Für diesen Fall kann die Form und/oder Leitfähigkeit des leitfähigen Deflektors 4 so modifiziert werden, dass die durch den faseroptischen Sensor 20 und/oder die optischen Versorgungsfasern 50 entstandene Veränderung des elektrischen Feldes kompensiert wird.

Im Vergleich zu außerhalb der Hochspannungsgarnitur angeordneten elektromagnetischen oder piezoelektrischen Sensoren oder Messaufbauten, deren Messempfindlichkeit während des Hochspannungsbetriebs durch elektromagnetische Grundstörpegel im Bereich von etwa 20 pC bis etwa 50 pC begrenzt ist, ermöglicht der mechanisch mit der Isolierung gekoppelte faseroptischen Sensor 20, 30 eine empfindlichere Detektion von Vibrationen der Isolierung und damit eine frühere Detektion von Teilentladungen. Neben der in Fig. 9 illustrierten vollständigen Einbettung Körpers 201 des faseroptischen Sensors 20, 30, ist es auch möglich, den Körper 201 des faseroptischen Sensors 20, 30 nur teilweise in das typischerweise elastomere Feldsteuerteil 3 einzubetten.

Die Anordnung des faseroptischen Sensors 20, 30 innerhalb der Hochspannungsgarnitur 100 schützt diesen außerdem vor äußeren Einflüssen, so dass zuverlässige und wartungsarme Sensoren für Teilentladungen zu Verfügung gestellt werden können.

Gemäß einer Weiterbildung werden mehrere faseroptischen Sensoren 20, 30 mechanisch mit der Isolierung 2, 3 gekoppelt. Damit kann die Messgenauigkeit weiter erhöht werden und/oder eine genauere Lokalisierung einer Teilentladungserscheinung in der Isolierung 2, 3 vorgenommen werden.

Fig. 10 zeigt eine Hochspannungsgarnitur 200 zur Aufnahme zweier Hochspannungskabel 1 und 22 gemäß einem Ausführungsbeispiel in einer schematischen zentralen Querschnittsansicht entlang der Zylinderachsen der koaxial orientierten Hochspannungskabel 1 und 22. Die rotationssymmetrischen Hochspannungskabel 1, 22 umfassen jeweils einen Leiter 11 bzw. 112 zum Leiten von Starkstrom und eine den jeweilige Leiter 11, 112 umgebende Kabelisolierung 12, 122. Die Hochspannungsgarnitur 200 stellt eine Hochspannungskabelmuffe zum Verbinden zweier Hochspannungskabel dar. Die Kabelmuffe 200 hat ein Gehäuse 210, z.B. ein Metallgehäuse, in dem die Hochspannungskabel 1 und 22 zentrisch angeordnet sind. Ein komplex aufgebauter elastomerer Muffenkonus mit Feldsteuerteilen 3, 32, die in ein Isoliergebiet 2 eingebettet sind und die das jeweils an den zusammengefügten Kabelenden auftretende Hochspannungsfeld definiert abbauen, übernimmt die Feldsteuerung der zu verbindenden Hochspannungskabel 1 und 22. Das Isoliergebiet 2 der Kabelmuffe 200 wird typischerweise von einem Gießharzisolator oder einem Silikonkörper gebildet. Weiterhin ist die Isolierung und Feldsteuerung im Bereich der verbundenen metallischen Leiter 11, 112 wieder herzustellen. Dies geschieht z.B. über z.B. eine Crimpverbindung und mit einem schwachleitfähigen Polymerring 7, die ebenfalls in das Isoliergebiet 2 eingebettet sind. Die typischerweise rotationssymmetrische Isolierung 2, 3, 32 der Kabelmuffe 200 wird von den Feldsteuerteilen 3, 23 und dem Isoliergebiet 2 gebildet. Außerdem kann das Isoliergebiet 2 durch eine nichtdargestellte äußere, leitfähige Muffenbeschichtung abgeschlossen sein, die auf der äußeren Oberfläche des Isoliergebiets 2 angeordnet ist, wobei ein kleiner Spalt zum Gehäuse 210 verbleiben kann, und die sich zusammen mit den Kabelschirmungen 13, 132 auf Erdpotential befindet. Typischerweise handelt es sich bei den Feldsteuerteilen 3, 32 um elastomere Feldsteuerteile 3, 32, in die ein jeweiliger leitfähiger Deflektor 4, 42 integriert ist. Die Kabelmuffe 200 kann in Komponentenbauweise, in Extrusionstechnik oder entsprechend der Wickeltechnik oder der Aufschiebetechnik ausgeführt sein. So kann die Isolierung der Kabelmuffe in Komponentenweise aus einem zusammenhängenden elastomeren Feldsteuerteil mit integrierten Deflektoren 4, 42 bestehen, das den Raum der in Fig. 5 gezeigten Feldsteuerteile 3, 32 und des Isoliergebiets 2 einnimmt, wobei ein kleiner Spalt zum Gehäuse 210 verbleiben kann, und das von einer äußeren, leitfähigen Muffenbeschichtung auf Erdpotential abgeschlossen ist. Die Isolierung umfasst aber unabhängig von der Herstellungstechnik zumindest ein Feldsteuerteil 3, 32 zur Aufnahme der Kabel 1, 22 mit an den jeweiligen Kabelenden entfernter Kabelisolierung 12, 122 und zur geeigneten Führung der Feldlinien im Hochspannungsbetrieb.

Gemäß einer Ausführungsform ist ein faseroptischer Sensor 20, 30 mit seinem Körper 201, wie er mit Bezug zu den Figuren 1 bis 2 beschrieben wurde, in dem Isoliergebiet 2 angeordnet bzw. in das Isoliergebiet 2 eingebettet. Dies bedeutet, dass es sich auch bei dem faseroptischen Sensor 20, 30 um einen Sensor handelt, der eine Schwingung, insbesondere eine Schallereignis empfindlich detektieren kann. Damit können auftretende Teilentladungen in der Isolierung 2, 3, 32 der Kabelmuffe 200 und der Kabelisolierungen 12, 122 über die mit Teilentladungen verbundenen Schallemissionen sicher nachgewiesen und einfach über längere Zeiträume während des Hochspannungsbetriebs beobachtet werden. Es versteht sich, dass der Körper 201 des faseroptischen Sensors 20, 30 auch in einen der beiden oder in beide Feldsteuerteile 3 und 32 eingebettet, oder an einer Oberfläche eines der beiden Feldsteuerteile 3 und 32 im jeweiligen sich auf Erdpotential befindenden kabelnahen Bereich 5, 52 sowie auf der leitfähigen Muffenbeschichtung angeordnet sein kann und das mehrere faseroptische Sensoren 20, 30 mechanisch mit dem Isoliergebiet 2 bzw. den beiden Feldsteuerteilen 3 und 32 mechanisch gekoppelt sein können.

Mit Bezug zu den Figuren 9 und 10 sind Ausführungsbeispiele von Kabelgarnituren beschrieben worden. Gemäß noch einem Ausführungsbeispiel handelt es sich bei der Hochspannungseinrichtung um eine Schaltanlage, z.B. einen Schaltschrank. Bei der Hochspannungseinrichtung kann es sich aber auch um einen Generator, einen Spannungswandler, z.B. einen Wechselrichter oder einen Transformator handeln. Auch in diesen Ausführungsformen kann mittels eines mit der jeweiligen Isolierung mechanisch gekoppelten faseroptischen Sensors eine einfache und empfindliche Detektion und/oder Quantifizierung von Teilentladungen in der Isolierung bereitgestellt werden.

In einem weiteren Ausführungsbeispiel wird der Körper 201 von mindestens einem faseroptischen Sensor 20, 30, wie er mit Bezug zu den Figuren 1 bis 2 beschrieben wurde, mechanisch mit Gestein- oder Betonteilen gekoppelt. Ein derartiger Aufbau kann zur Detektion und/oder Quantifizierung und/oder zum Monitoring mikroakustischer Ereignisse, die durch Spannungsrisse im Gestein bzw. Beton hervorgerufen werden können, z.B. im Bergbau bzw. Tunnelbau eingesetzt werden.

Gemäß einem Ausführungsbeispiel wird ein Verfahren zur Detektion von Teilentladungen in einer Isolierung einer Hochspannungsanlage, z.B. einer Hochspannungskabelgarnitur, wie sie mit Bezug zu den Figuren 9 und 10 beschrieben wurde, angegeben. Das Verfahren umfasst die Messung einer eine Schwingung charakterisierenden Größe der Isolierung mittels eines faseroptischen Sensors, wie er mit Bezug zu den Figuren 1 und 2 erläutert wurde, der mechanisch mit der Isolierung gekoppelt ist. Typischerweise wird das Verfahren mit einer Messanordnung ausgeführt, wie sie mit Bezug zu den Figuren 3 bis 8 erläutert wurde. Wenn durch eine Teilentladung ein Schallereignis in der Isolierung ausgelöst wird, kann dieses über dem faseroptischen Sensor hochempfindlich detektiert und typischerweise sogar quantifiziert werden. So kann vorgesehen sein mehrere faseroptische Sensoren mechanisch mit der Isolierung zu koppeln. Damit lassen sich der Ort und der Zeitpunkt bzw. Zeitverlauf des Schallereignisses bestimmen. Die Stärke der Teilentladung kann dann aus einer maximalen Biegeschwingungsamplitude des biegeschwingungsfähigen Endstücks von einem oder mehreren der faseroptischen Sensoren ermittelt oder zumindest abgeschätzt werden.

Die Messung einer eine Schwingung charakterisierenden Größe erfolgt typischerweise im stromdurchflossenen Zustand der Hochspannungsanlage während des Betriebs. Dies ermöglicht zudem eine kontinuierliche oder ereignisabhängige Messung der mechanischen Größe, d.h. ein Monitoring von Teilentladungen im laufenden Betrieb. Dadurch kann die Sicherheit Hochspannungsanlage und/oder eines Hochspannungsnetzes, deren Isolierungen mit integrierten faseroptischen Sensoren überwacht werden, wesentlich verbessert werden.

Die vorliegende Erfindung wurde anhand von Ausführungsbeispielen erläutert. Diese Ausführungsbeispiele sollten keinesfalls als einschränkend für die vorliegende Erfindung verstanden werden.

## Patentansprüche

1. Faseroptischer Sensor (20, 30) zur Erfassung einer eine Schwingung charakterisierende Größe, umfassend:
- einen Körper (201) mit einem Hohlraum (202);
- einen ersten Lichtleiter (21) mit einem Endstück (211), das in dem Hohlraum (202) angeordnet ist und eine zu seiner Faserachse (215) nicht senkrecht verlaufende Stirnfläche (213) aufweist; und
- einen zweiten Lichtleiter (22) mit einem Endstück (221), das in dem Hohlraum (202) biegeschwingungsfähig angeordnet ist, das in einer Ruhelage koaxial zu dem Endstück (211) des ersten Lichtleiters (21) ist, und das eine zu seiner Faserachse (225) nicht senkrecht verlaufende Stirnfläche (223) aufweist, die in der Ruhelage im Wesentlichen parallel zur Stirnfläche (213) des ersten Lichtleiters (21) ist.

2. Faseroptischer Sensor (20, 30) nach Anspruch 1, wobei der erste Lichtleiter (21) und der zweite Lichtleiter (22) eingerichtet sind, ein Lichtsignal zu transportieren, dass eine erste Wellenlänge umfasst, und wobei die Faserachse (225) des zweiten Lichtleiters (22) und eine Tangente an die Stirnfläche (213) des zweiten Lichtleiters (22) einen Winkel bilden, der einem Totalreflektionswinkel für die erste Wellenlänge entspricht.

3. Faseroptischer Sensor (20, 30) nach Anspruch 1 oder 2, wobei die Stirnfläche (213) des zweiten Lichtleiters (22) in einem Winkel von etwa 45° zur Faserachse (225) des zweiten Lichtleiters (22) verläuft.

4. Faseroptischer Sensor (20, 30) nach einem der vorangegangenen Ansprüche, wobei der erste Lichtleiter (21) und der zweite Lichtleiter (22) eingerichtet sind, ein Lichtsignal zu transportieren, dass eine erste Wellenlänge umfasst, und wobei ein minimaler Abstand (d) zwischen der Stirnfläche (213) des Endstücke (211) des ersten Lichtleiters (21) und der Stirnfläche (223) des Endstücke (221) des zweiten Lichtleiter (22) in der Ruhelage kleiner als die erste Wellenlänge ist.

5. Faseroptischer Sensor (20, 30) nach einem der vorangegangenen Ansprüche, wobei die Stirnfläche (213) des ersten Lichtleiters (21) eine konvexe Oberfläche bildet, dessen Krümmungsradius wesentlich größer als ein Durchmesser des ersten Lichtleiter (21) ist, und/oder wobei die Stirnfläche (223) des zweiten Lichtleiters (22) eine konvexe Oberfläche bildet, dessen Krümmungsradius wesentlich größer als ein Durchmesser des zweiten Lichtleiters (22) ist.

6. Faseroptischer Sensor (20, 30) nach einem der vorangegangenen Ansprüche, wobei das Endstück (221) des zweiten Lichtleiters (22) durch Schallwellen anregbar ist, Biegeschwingungen bei mindestens einer Frequenz aus einem Bereich von etwa 5 kHz bis etwa 500 kHz auszuführen.

7. Faseroptischer Sensor (20, 30) nach einem der vorangegangenen Ansprüche, wobei das Endstück (221) des zweiten Lichtleiters (22) eine Resonanzfrequenz für Biegeschwingungen aus einem Bereich von etwa 5 kHz bis etwa 500 kHz aufweist.

8. Faseroptischer Sensor (20, 30) nach einem der vorangegangenen Ansprüche, wobei der Körper (201) eine Glaskapillare oder eine Glasküvette umfasst.

9. Messeinrichtung (60) zur Detektion von mechanischen Schwingungen, umfassend:
- einen faseroptischen Sensor (20, 30) nach einem der vorangegangenen Ansprüche;
- einen ersten Fotodetektor (61), der mit dem ersten Lichtleiter (21) oder mit dem zweiten Lichtleiter (22) optisch gekoppelt ist;
- eine Lichtquelle (64) zum Aussenden eines Lichtsignals (641);
- einen dritten Lichtleiter (23);
- einen mit dem dritten Lichtleiter (23) optisch gekoppelten zweiten Fotodetektor (62); und
- einen optischen Koppler (63), der eingerichtet ist, das Lichtsignal (641) zumindest teilweise in den zweiten Lichtleiter (22) oder den ersten Lichtleiter (21) einzuspeisen und ein durch den zweiten Lichtleiter (22) oder den ersten Lichtleiter (21) rücklaufendes Lichtsignal (633) zumindest teilweise in den dritten Lichtleiter (23) einzuspeisen.

10. Messeinrichtung (60) nach Anspruch 9, wobei die Messeinrichtung (20) eingerichtet ist, einen Abstand und/oder eine Amplitude einer Schwingung zwischen der Stirnfläche (213) des Endstücks (211) des ersten Lichtleiters (21) und der Stirnfläche (223) des Endstücks (221) des zweiten Lichtleiters (22) über eine Messung einer evaneszent zwischen dem zweiten Lichtleiter (22) und dem ersten Lichtleiter (21) ausgetauschten Lichtleistung und/oder einer Lichtmenge zu bestimmen.

11. Messeinrichtung (60) nach Anspruch 9 oder 10, wobei die Messeinrichtung (60) eingerichtet ist, einen Abstand und/oder eine Amplitude einer Schwingung zwischen der Stirnfläche (213) des Endstücks (211) des ersten Lichtleiters (21) und der Stirnfläche (223) des Endstücks (221) des zweiten Lichtleiters (22) über eine Messung einer Lichtleistung und/oder Lichtmenge des aus dem Hohlraum (202) in den zweiten Lichtleiter (22) rücklaufenden Lichtsignals (633) zu bestimmen.

12. Hochspannungseinrichtung (100, 200) zur Aufnahme eines Hochspannungskabels (1, 22) mit einem zum Leiten elektrischen Stroms eingerichteten Leiter (11, 112) und einer den Leiter (11, 112) umgebenden Kabelisolierung (12, 122), umfassend:
- eine Isolierung (2, 3, 32), die eingerichtet ist, Kabelisolierung (12, 122) zumindest teilweise zu umgeben; und
- einem faseroptischen Sensor (20, 30) nach einem der Ansprüche 1 bis 8, und/oder
- einer Messeinrichtung (60) nach einem der Ansprüche 9 bis 11;
wobei der Körper (201) des faseroptischen Sensors (20, 30) mit der Isolierung (2, 3, 32) mechanisch gekoppelt ist.

13. Hochspannungseinrichtung (100, 200) nach Anspruch 12, wobei der Körper (201) des faseroptischen Sensors (20, 30) im Innern der Hochspannungseinrichtung (100, 200) angeordnet ist.

14. Verfahren zur Detektion einer Teilentladung in einer Isolierung (2, 3, 32) einer Hochspannungsanlage (100, 200), umfassend:
- Messung einer eine Schwingung charakterisierende Größe der Isolierung (2, 3, 32) mittels eines faseroptischen Sensors (20, 30) nach einem der Ansprüche 1 bis 8, dessen Körper (201) mechanisch mit der Isolierung (2, 3, 32) gekoppelt ist.

15. Verfahren nach Anspruch 14, wobei die Messung einer eine Schwingung charakterisierende Größe im stromdurchflossenen Zustand der Hochspannungseinrichtung durchgeführt wird.
